Europäisches Patentamt

European Patent Office

Office européen des brevets

(19)

(11) Veröffentlichungsnummer: **0 098 931**

A2

(12) **EUROPÄISCHE PATENTANMELDUNG**

(21) Anmeldenummer: 83104465.6

(22) Anmeldetag: 06.05.83

(51) Int. Cl.³: **G 03 F 1/00**
**G 03 F 7/12**

(30) Priorität: 14.07.82 DE 3226297

(43) Veröffentlichungstag der Anmeldung:
25.01.84 Patentblatt 84/4

(84) Benannte Vertragsstaaten:
AT CH FR GB IT LI NL SE

(71) Anmelder: **Dr. Johannes Heidenhain GmbH**
**Nansenstrasse 17**
**D-8225 Traunreut(DE)**

(72) Erfinder: **Kraus, Heinz**
**Traunring 74e**
**D-8225 Traunreut(DE)**

(54) Verfahren zum Herstellen freitragender strukturierter Folien.

(57) Bei diesem Herstellungsverfahren für freitragende, präzise Teilungsstrukturen aufweisende Folien wird die fotolithografisch aufgebrachte Maske nach dem Anätzen als partieller Ätzschutz verwendet, indem man die Folie erhitzt und an der unterätzten Partie die Maske umschmilzt, so daß sich an der unterätzten Kante ein Schutzfilm bildet. So dann wird weitergeätzt bis die Struktur durchgeätzt ist. Die dabei wieder entstehende Unterätzung ist ohne Belang, da die teilungsbildende Kante ja zuvor abgedeckt wurde.

FIG.3

EP 0 098 931 A2

0098931

- 1 -

DR. JOHANNES HEIDENHAIN GMBH          6. Juli 1982

Verfahren zum Herstellen freitragender strukturierter
Folien
=======================================================

Die Erfindung bezieht sich auf ein Verfahren zum
Herstellen von freitragenden, präzise Teilungsstrukturen aufweisenden Folien gemäß dem Oberbegriff
des Anspruches 1.

Derartige strukturierte, freitragende Folien werden
z.B. als Impulsscheiben oder auch als Bedampfungsmasken auf verschiedenen Gebieten der Technik benötigt. Bei solchen durch Ätzen hergestellten Folien
ist es wegen der den Herstellungsverfahren eigenen
Mängeln praktisch nicht möglich, maßlich eng
tolerierte Strukturen herzustellen.

Die erreichbare Präzision ist von der vorgegebenen
Dicke des Materials, dessen Eigenschaften und den
Eigentümlichkeiten des Ätzverfahrens abhängig.

Die Kantenverlagerung kann im Prinzip durch Maßvor-

- 2 -

halte auf der Negativ-Vorlage oder durch Zwischenabdeckung mit einer separaten Schutzschicht kompensiert werden. Eine Maßhaltigkeit höherer Ordnung
ist aber in der Praxis nicht erreichbar. Ein derartiges Verfahren ist beispielsweise in der
DE-OS 21 13 829 beschrieben.

Aufgabe der Erfindung ist es, die Nachteile der bekannten Verfahren zum Herstellen freitragender
Strukturen zu vermeiden und ein Verfahren anzugeben, mit dem freitragende, präzise Teilungsstrukturen aufweisende Folien in wenigen Arbeitsschritten einfach und kostengünstig herstellbar
ist.

Diese Aufgabe wird durch die im kennzeichnenden
Teil des Anspruchs 1 angegebenen Verfahrensschritte
gelöst.

Der Vorteil dieses Verfahrens liegt darin, daß
die erzielbare Genauigkeit der Teilungsstrukturen
und deren maßliche Toleranzen sehr hoch ist, und
daß dennoch zusätzlicher Maskierungsaufwand zur
Zwischenabdeckung nicht erforderlich ist, da der
Ätzschutz sich aus der bereits vorhandenen Maske
herstellen läßt.

Anhand der stark vergrößert darstellenden Zeichnungen wird die Erfindung noch näher erläutert.

0098931

- 3 -

Es zeigt

Figur 1 einen Ausschnitt im Kantenbereich
einer angeätzten Feinstruktur,

Figur 2 einen Ausschnitt im Kantenbereich
einer Feinstruktur, bei der eine
unterätzte Maske umgeschmolzen
ist,

Figur 3 einen Ausschnitt im Kantenbereich
einer Feinstruktur nach der Ätzung.

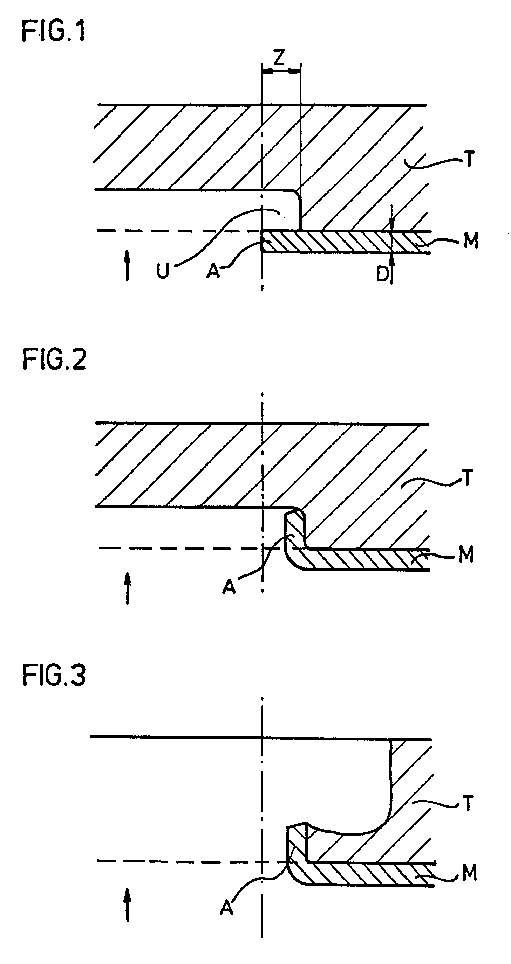

Der in Figur 1 dargestellte stark vergrößerte Ausschnitt einer Kante A einer Feinstruktur ist gemäß Stand der Technik fotolithografisch aufgebracht.

Die fotolithografisch aufgebrachte Maske M bestimmt die Teilungsstruktur. Durch die bekanntlich bei Ätzverfahren immer auftretende Unterätzung U wird sich die Kante A der Teilungsstruktur um den Betrag Z verlagern.

Nach dem Ätzen gemäß Figur 1 wird die Ätzung unterbrochen, und die Kante A der Maske M wird umgeschmolzen, so daß sich an der Unterätzung U, wie in Figur 2 gezeigt, ein partieller Flankenschutz bildet. Danach wird weiter in Pfeilrichtung geätzt, bis die Trägerfolie T an den vorgesehenen Partien durchgeätzt ist.

Wie aus Figur 3 ersichtlich, tritt bei der Durchätzung wieder die übliche Unterätzung auf, was jedoch ohne negative Auswirkungen für die Maßhaltigkeit der Teilungsstruktur bleibt.

- 4 -

Nimmt man als praktisches Beispiel ein Trägerblech T aus Be-Bronze mit einer Dicke von 50μm an
und eine Fotolackdicke von 2μm (für Kantendefinition im μm-Bereich), dann ergibt sich eine Kantenverlagerung Z von ca. 2 bis 3μm und eine Streuung
der Kantenlage (20 %) von $0,2 \cdot Z < 1μm$.

Damit sind nach diesen Verfahren gefertigte Folien
etwa um den Faktor 10 genauer als ein herkömmlich
in einem Schritt durchgeätzter Träger T, für den
sich eine Streuung der Kantenlage von ca. 10μm errechnen läßt.

Es ist somit möglich, mit einem einfachen und an
sich billigen Prozessablauf sehr genaue freitragende Teilungen auch aus relativ dicken Trägerblechen anzufertigen und so sehr genaue Folien herzustellen.

Die Fotolackmaske M kann als Oberflächenschutzfilm
z.B. gegen Oxydation auf der Trägerfolie verbleiben.

- 5 -

Patentansprüche
================

1.) Verfahren zum Herstellen von freitragenden, präzise Teilungsstrukturen aufweisenden Folien, bei denen die Teilungsstruktur vorzugsweise durch fotolithografische Maskierung auf der Trägerfolie aufgebracht ist, und bei dem die Trägerfolie durch einseitiges, mehrstufiges Ätzen an den nicht abgedeckten Partien entfernt wird, gekennzeichnet durch folgende Verfahrensschritte:

  a.) Anätzen der Trägerfolie (T) bis zur geringfügigen Unterätzung (U) der Maske (M);
  b.) Unterbrechen des Ätzvorganges und Umschmelzen der hinterschnittenen Maske (M);
  c.) Durchätzen der Trägerfolie (T);
  d.) gegebenenfalls Entfernen der Maske (M).

2.) Verfahren nach Anspruch 1, dadurch gekennzeichnet, daß die Maske (M) als Oberflächenschutzfilm auf der Trägerfolie (T) verbleibt.

3.) Verfahren nach Anspruch 1, dadurch gekennzeichnet, daß der einseitige Ätzvorgang als Sprühstrahlätzung durchgeführt wird.

FIG.1

FIG.2

FIG.3